Europäisches Patentamt

European Patent Office

Office européen des brevets

(19)

(11) Veröffentlichungsnummer: **0 668 335 A2**

## (12) EUROPÄISCHE PATENTANMELDUNG

(21) Anmeldenummer: **95101657.5**

(22) Anmeldetag: **08.02.95**

(51) Int. Cl.6: **C09J 7/02**

(30) Priorität: **17.02.94 DE 4404955**

(43) Veröffentlichungstag der Anmeldung:
**23.08.95 Patentblatt 95/34**

(84) Benannte Vertragsstaaten:
**DE FR GB IT**

(71) Anmelder: **Beiersdorf Aktiengesellschaft
Unnastrasse 48
D-20245 Hamburg (DE)**

(72) Erfinder: **Lühmann, Bernd Dr.
Heidbergstrasse 55
D-22846 Norderstedt (DE)**
Erfinder: **Karmann, Werner Dr.
Stolpmünder Strasse 11
D-22147 Hamburg (DE)**
Erfinder: **Wieck, Andreas
Ulmenweg 1a
D-25449 Halstenbek (DE)**

(54) **Klebeband mit Nachvernetzungsreserve.**

(57) Gegenstand der Erfindung sind Haftklebematerialien, insbesondere blattförmige oder bahnförmige Materialien mit einseitig oder beidseitig aus der Schmelze aufgetragener Haftklebemasseschicht, dadurch gekennzeichnet, daß die Haftklebemasseschicht vernetzt ist und auf eine reaktive Primerschicht aufgetragen ist.

EP 0 668 335 A2

Abb. 1

Beispiel 1

Die Erfindung betrifft Haftklebematerialien mit aus der Schmelze aufgetragenen Haftklebemassen, die vernetzt sind.

Schmelzhaftklebstoffe Zeichnen sich insbesondere durch die Möglichkeit aus, während der Klebmasseherstellung und der Beschichtung von Folienmaterial zum Zwecke der Herstellung von Selbstklebebändern lösungsmittelfrei zu arbeiten. Weitere Vorteile schließen die Möglichkeiten ein, kleine, kompakte Beschichtungseinheiten einzusetzen, bei hohen Bahngeschwindigkeiten zu beschichten sowie hohe Masseaufträge in einem Beschichtungsgang zu realisieren.

Als besonders geeignet für den Einsatz in Schmelzhaftklebern erweisen sich Blockcopolymere mit Blöcken bestehend aus Homo- oder Copolymeren von 1,3-Dienen respektive deren Hydrierungsprodukte. Solche Polymere sind in der Literatur beschrieben (E.E.Erwins et al in "Handbock of PSA Technology"; Ed.: D. Satas; Chapter 13; van Nostrand Reinhold, New York (1989)).

Besondere Bedeutung kommt Verbindungen zu, in denen als Polyvinylaromat Styrolhomopolymer Verwendung findet (Nachfolgend als Styrolblockcopolymere bezeichnet). Polyvinylaromatenblöcke und Polydienblöcke zeichnen sich durch physikalische Unverträglichkeit aus und separieren in räumlich getrennte Bereiche, welche auch als Domänen bezeichnet werden. Die ausgebildete Domänenstruktur ist im wesentlichen durch das Volumenverhältnis von Polyvinylaromatenblöcken zu Polydienblöcken bestimmt. Geeignete Volumenverhältnisse (Domänenstruktur) vorausgesetzt, verfügen die beschriebenen Blockcopolymere über die besonderen Eigenschaften eines thermoplastischen Elastomers, wobei die Polydienblöcke dem Produkt die elastischen Eigenschaften verleihen, während die Polyvinylaromatenblöcke die kohäsiven Eigenschaften steuern.

Systembedingt weisen Heißschmelzklebemassen auf Basis thermoplastischer Elastomere nur eine begrenzte Temperaturbeständigkeit auf. Bei Annäherung an den Erweichungspunkt (Glasübergangstemperatur) der von den verwendeten Polyvinylaromaten gebildeten Domänen verlieren die Klebemassen an Kohäsivität. Sie sind daher für Anwendungen, die auch bei hohen Temperaturen eine ausreichende Scherfestigkeit der Selbstklebebänder fordern nicht einsetzbar. Obere Gebrauchstemperaturen liegen für Styrolblockcopolymere je nach Anwendung i.a. im Bereich zwischen $+60\,^{\circ}C$ und $+100\,^{\circ}C$.

Mit dem Ziel, den Anwendungsbereich von Selbstklebebändern mit Haftschmelzklebemassen auf Basis von Styrolblockcopolymeren zu höheren Temperaturen zu verschieben, sind mehrere Wege beschrieben worden. Möglichkeiten sind:

der Einsatz von Vinylaromatenblöcken, welche zu Produkten mit höheren Domänenerweichungspunkten führen, z.B. die Verwendung von Styrol-$\alpha$-Methylstyrolblöcken anstelle von Styrolhomopolymerblöcken, der Zusatz von Stoffen mit hohen Erweichungspunkten, welche sich bevorzugt auf die von den Polyvinylblöcken gebildeten Domänen verteilen (endblockkompatible Harze) und welche den Erweichungsbereich der Polyvinylaromatendomänen zu höheren Temperaturen verschieben. Beispiele hierfür sind $\alpha$-Methylstyrolhomopolymere und Styrol-$\alpha$-Methylstyrolcopolymere. In EP-A-0 001 206 ist mit gleicher Zielrichtung die Integration von Polyphenylenether in Styrolblockcopolymere beschrieben.

Nachteil der vorgestellten Methoden ist eine erschwerte Verarbeitbarkeit der Schmelzhaftklebemassen, welche durch die hohen Erweichungspunkte der zu verwendenden Zumischkomponenten und durch die zu höheren Temperaturen verschobenen Erweichungspunkte der Polyvinylaromatendomänen bedingt ist. Höhere Schmelzviskositäten und eine stärkere thermische Belastung der Klebemassen während der Verarbeitung sind die Folge. Die praktisch zu erreichenden Verbesserungen der Scherstandzeiten bleiben dadurch begrenzt. Gleichzeitig bewirken Zusätze von endblockverträglichen Harzen oft eine Verschlechterung weiterer klebtechnischen Eigenschaften der Selbstklebemassen, wie z.B. eine Erniedrigung der Anfaßklebrigkeit.

Eine verbreitete Methode, Haftklebemassen mit auch bei hohen Anwendungstemperaturen ausgezeichneter Scherfestigkeit zu erhalten, besteht in der chemischen oder strahlenchemischen Vernetzung der Selbstklebemassen. Für Schmelzhaftkleber findet die nachträgliche Vernetzung über hochenergetische Strahlung während der Herstellung des Selbstklebebandes Anwendung. Als besonders geeignet haben sich die Vernetzung durch UV-Strahlung und die Vernetzung über Elektronenbestrahlung erwiesen (J.R.Erickson; TAPPI Hot Melt Symposium, 1-12 (1985); J.R.Erickson; Techn. Sem. Proc., 76-97 (1985)). Um allerdings Anwendungstemperaturen im Bereich von größer ca. $120\,^{\circ}C$ bis $+140\,^{\circ}C$ zu erreichen müßte die Strahlenvernetzung bis zu so hohen Vernetzungsdichten durchgeführt werden, daß die Verklebung insbesondere auf rauhen Verklebungsuntergründen zu schwach wird. Zusätzlich beobachtet man bei hohen Strahlendosen in vielen Fällen eine irreversible Schädigung der übrigen Bestandteile des Selbstklebebandes, welche die Qualität des Produktes oft nachteilig beeinflußt.

Thermisch hoch belastbare Selbstklebemassen werden u.a. durch Zugabe von reaktiven Phenolharzen, z.B. Alkylphenolharzen zur Klebemasse erhalten (A. Giller; Kautschuk und Gummi, Kunststoffe 19, 188-197 (1966)). Der auch als Harzvulkanisation bezeichnete Prozess ist dadurch gekennzeichnet, daß die Vernetzung der Selbstklebemasse je nach Art und Einsatzkonzentration des verwendeten Harzes und Beschleunigersystems erst bei Temperaturen im Bereich zwischen ca. +120°C bis über +160°C abläuft. Die Harzvulkanisation eignet sich insbesondere auch für Anwendungen bei denen eine Vernetzung oder Nachvernetzung der Klebemasse erst unter Einsatzbedingungen im zuvor genannten Temperaturbereich erwünscht ist. Über den Prozess der Harzvulkanisation vernetzbar sind Klebemassen auf Naturkautschukbasis sowie solche auf Basis ungesättigter Synthesekautschuke.

Das Prinzip der Harzvulkanisation ist auf Schmelzhaftklebemassen nur sehr begrenzt anwendbar, da diese während der Kleberherstellung sowie beim Auftragen des Klebers auf das Trägermaterial naturbedingt auf hohe Temperaturen erwärmt werden müssen, um die Schmelzviskosität in einem Bereich zu halten, welcher eine gute Verarbeitbarkeit gewährleistet und so die Gefahr besteht, daß die Vernetzungsreaktion schon während der Herstellungsprozesse einsetzt.

In der DE OS 26 49 028 werden verschiedene Verfahren vorgeschlagen, um vorgenannte Schwierigkeiten zu umgehen. Solche der dort aufgeführten Verfahren, bei denen die Reaktivharze vor dem Auftrag der Schmelzhaftklebemasse zugemischt werden, setzen niedrige Verarbeitungstemperaturen und/oder kurze Verweilzeiten voraus, die den Einsatz unter praktischen Bedingungen stark einschränken. Weiterhin werden drei Methoden genannt in denen die Reaktivharze separat von der Schmelzhaftklebemasse aufgetragen werden und die Vernetzungsreaktion (hier als "Copolymerisation" bezeichnet) nachfolgend auf dem Träger abläuft:

A) Zunächst wird der Träger mit der Reaktivharzkomponente beschichtet, anschließend wird die Klebemasse darüber aufgetragen,

B) Die Reaktivharzkomponente wird auf die Rückseite des Trägers aufgetragen, die Klebemasse auf die Vorderseite. Die Reaktion erfolgt beim Aufrollen des Klebebandes,

C) Zunächst wird der Träger mit der Klebemasse beschichtet, anschließend wird die Reaktivharzkomponente darüber aufgetragen.

Alle drei Verfahren setzen voraus, daß die Reaktivharzkomponente nach Kontakt mit dem Schmelzhaftkleber in die Klebemasse diffundiert und dann spontan die Vernetzungsreaktion eintritt. Dieses ist bei den üblichen Vulkanisationsharzen nicht der Fall. Bei dem unter A) beschriebenen Verfahren besteht darüberhinaus die Schwierigkeit, daß eine Harzschicht die Haftung der Klebemasse zum Träger schwächt, sofern das Vulkanisationsharz nicht vollständig in die Klebmasseschicht eindiffundiert.

Aufgabe vorliegender Erfindung war es, schmelzhaftkleberbeschichtete Selbstklebematerialien bereitzustellen, welche im Bereich höherer Temperaturen, insbesondere bis in den Temperaturbereich von +120°C bis über +180°C hohe Scherfestigkeit aufweisen und gleichzeitig die in der DE OS 26 49 028 beschriebenen Schwierigkeiten auszuschließen.

Diese Aufgabe wird gelöst durch Haftklebematerialien, insbesondere blattförmige oder bahnförmige Materialien mit einseitig oder beidseitig aus der Schmelze aufgetragener Haftklebemasseschicht, die dadurch gekennzeichnet sind, daß die Haftklebemasseschicht vernetzt ist und auf eine reaktive Primerschicht aufgetragen ist.

Die Lösung besteht insbesondere in Haftklebematerialien mit einem Träger, insbesondere blattförmigen oder bahnförmigen Materialien mit einseitig oder beidseitig aus der Schmelze aufgetragener Haftklebemasseschicht, die dadurch gekennzeichnet sind, daß die Haftklebemasseschicht vorvernetzt ist und auf eine reaktive Primerschicht aufgetragen ist, die zuvor auf die Materialien aufgebracht wurde und die durch nachträglich erfolgende Erwärmung eine zusätzliche Vernetzung der Haftklebemasse bewirkt.

Die erfindungsgemäße reaktive Primerschicht enthält einen Primer und einen Vernetzer, vorzugsweise Vulkanisationsharze, für die Haftklebemasse.

Erfindungsgemäße Selbstklebematerialien enthalten Vernetzungsmittel in einem zwischen Trägermaterial und Haftklebemasse befindlichen Vorstrich (Primer), der vor der Nachstrichbeschichtung mit Haftklebemassen in einem separaten Beschichtungsschritt auf den Träger aufgebracht wird. Die Aufgabe des Primers ist einerseits wie üblich eine ausgezeichnete Haftung der Haftklebemasse auf dem verwendeten Trägermaterial zu vermitteln, zum zweiten stellt er das Reservoir für die zur Vernetzung der Haftklebemasse nötigen Vernetzer dar.

Da die Vernetzungsreaktion, insbesondere die Harzvulkanisation, typischerweise erst bei Temperaturen oberhalb etwa +100°C bis +140°C einsetzt, ist für die Funktionstüchtigkeit der beschriebenen Haftklebematerialien die Einstellung eines geeigneten Vorvernetzungsgrades zweckmäßig: Eine zu geringe Vorvernetzung führt bei Erwärmung des Klebebandes zu einer zu starken Erweichung der Klebemasse und kann damit zu einem Lösen der Verklebung unter Scherbeanspruchung führen. Andererseits verschlechtert eine zu starke Vernetzung die Verklebungsfähigkeit des Klebebandes auf rauhen Untergründen und kann daher ebenfalls zu einem Lösen der Verklebung führen. Die Einstellung des Vorvernetzungsgrades kann in jeder gewünschten Weise erfolgen und wird z.B. chemisch oder vorteilhafterweise durch Strahlenvernetzung vorgenommen, insbesondere über UV-Strahlung oder Bestrahlung mit schnellen Elektronen.

Als Schmelzhaftklebemassen eignen sich bevorzugt solche, welche als Basispolymer thermoplastische Elastomere, insbesondere oben vorgestellte Blockcopolymere enthalten, soweit diese über Strahlenhärtung vorvernetzbar sind. Dies gilt insbesondere für die in der Literatur (J.R.Erickson; TAPPI Hot Melt Symposium, 1-12 (1985); J.R.Erickson; Techn. Sem. Proc., 76-97 (1985)) beschriebenen sternförmigen Multiblockcopolymere der allgemeinen Formel (A-B)nX, wobei an eine Komponente X n Zweiblockarme mit Blöcken A (Polyvinylaromatenblock) und Blöcken B (Polydienblock) angekoppelt sind. Geeignet hohe Molmasse, Armzahl n und geeignetes Volumenverhältnis von A und B vorausgesetzt, eignen sich diese Systeme besonders für den Einsatz in strahlenhärtbaren Schmelzhaftklebstoffen. Jedoch lassen sich z.B. auch A-B Zwei-, A-B-A Drei- und lineare (A-B)n-Multiblockcopolymere sowie Gemische derselben verwenden, wenn diesen geeignete Vernetzer als Hilfsstoffe zugesetzt werden. Beispiele für geeignete Vernetzer sind multifunktionelle (Meth-)Acrylate wie z.B. TMPTA oder auch Polythiole wie sie in US-A-4,820,746 beschrieben werden. Auch Mischungen von sternförmigen Blockcopolymeren mit linearen 2-, 3- und Multiblockcopolymeren sind erfindungsgemäß einsetzbar.

Als besonders geeignet für den Einsatz in den Schmelzhaftklebern erweisen sich Blockcopolymere, welche bevorzugt Blöcke bestehend aus Homo- oder Copolymeren (auch als Elastomerblock bezeichnet) von 1,3-Dienen, (bevorzugt Polyisopren und Polybutadien), respektive deren Hydrierungsprodukte, (bevorzugt Poly(Ethylen-Butylen) und Poly(Ethylen-Propylen), (E.E.Erwins et al in "Handbock of PSA Technology"; Ed.: D. Satas; Chapter 13; van Nostrand Reinhold, New York (1989)) und Blöcke bestehend aus Polyvinylaromaten enthalten. Besondere Bedeutung kommt Verbindungen zu in denen als Polyvinylaromat Styrolhomopolymer Verwendung findet (nachfolgend als Styrolblockcopolymere bezeichnet). Polyvinylaromatenblöcke und Elastomerblöcke sind meist derart verknüpft, daß A-B-Zweiblock (A = Polyvinylaromatenblock, B = Elastomerblock), A-B-A-Dreiblock-, lineare $(AB)_n$-Multiblock-, radiale $(AB)_n$-Multiblock-$(C_n = 3,4)$ oder sternförmige $(AB)_n$-Multiblock-(n > 4) Copolymere entstehen.

Als Abmischkomponente der vorgenannten Blockcopolymere bzw. deren Mischungen, zur Einstellung der gewünschten klebtechnischen Eigenschaften, können die üblichen Naturharze, modifizierten Naturharze und Syntheseharze, Weichmacher, Füllstoffe und Alterungsschutzmittel Anwendung finden.

Als Trägermaterialien können alle bekannten Träger, z.B. sowohl Folienträger, Papierträger, Vliesträger als auch Gewebeträger verwendet werden, geeignete thermische Stabilität des Trägers vorausgesetzt. Je nach Einsatzzweck können die Träger vor den Arbeitsgängen Primerung und Nachstrichbeschichtung mehrere Veredelungsstufen durchlaufen. Beispiele für Veredelungsverfahren sind Imprägnierung, Releasebeschichtung und Druckvorbehandlung.

Als Primer können übliche Primer, z.B. Lösungsmittelsysteme oder wässrige Dispersionssysteme verwendet werden. Wesentliche Aufgabe des Primers ist es einerseits, eine gute Verankerung der Selbstklebemasse auf dem zu verwendenden Träger zu gewährleisten. Die jeweilige Primer-Basisrezeptur ist somit in bekannter Weise auf die speziellen Verhältnisse des Einzelfalles (Art des Trägers, Klebmassetyp) einzustellen. Zum zweiten dient der Primer erfindungsgemäß als Matrix für die reaktive Komponente oder den Vernetzer, insbesondere mindestens einem Vulkanisationsharz. Der Vernetzer bzw. Vulkanisationsharzgehalt liegt typischerweise im Bereich zwischen 0,2 und 10 Gew.-Teilen bezogen auf 100 Gew.-Teile Blockcopolymer des Schmelzhaftklebers und bevorzugt im Bereich zwischen 1 und 6 Gew.-Teilen Vernetzer pro 100 Gew.-Teile Blockcopolymer des Schmelzhaftklebers, jedoch können auch höhere Anteile an Vernetzer verwendet werden. Die Primeraufträge liegen typischerweise zwischen 0.5 und 12 $g/m^2$ (Feststoff). Als Vulkanisationsharze eignen sich insbesondere reaktive Phenolharze, z.B. Alkylphenolharze, welche durch Umsetzung von Phenolen mit Formaldehyd im basischen Reaktionsmedium erhalten werden können, wie in der Literatur (A. Giller; Kautschuk und Gummi, Kunststoffe 19, 188-197 (1966)) beschrieben. Die Methylolwerte der eingesetzten Produkte liegen bevorzugt zwischen 4 und 20%.

Neben dem Vernetzer bzw. Vulkanisationsharz enthält der Primer vorzugsweise 30 bis 80 Gew.-Teile pro 100 Gew.-Teile Filmbildner, 0 bis 50 Gew.-Teile pro 100 Gew.-Teile Füllstoffe, 0 bis 10 Gew.-Teile pro 100 Gew.-Teile Vulkanisationsbeschleuniger sowie 0 bis 20 Gew.-Teile pro 100 Gew.-Teile Primer weitere Bestandteile, wie z.B. Benetzungsmittel, Viskositätsregler, Entschäumer, Alterungsschutzmittel, wie sie als Primerzusätze bekannt sind.

Dem Primer und/oder dem Schmelzhaftkleber können Hilfsstoffe zugesetzt sein, welche eine Beschleunigung der Harzvulkanisation sowie ein Verschieben der Vulkanisation in den Bereich niedrigerer Temperaturen bewirken. Geeignete Hilfsstoffe sind organische Zinkspender wie Zinkresinat, Zinkstearat oder auch Zinkoxid, letzteres insbesondere in Kombination mit säuregruppenhaltigen Komponenten wie sauren Harzen oder aliphatischen Carbonsäuren. Halogenspender wie halogenhaltige Harze oder halogenhaltige Polymere bewirken insbesondere in Kombination mit Zn-Spendern eine zusätzliche Beschleunigung der Harzvulkanisation, wobei die vulkanisationsbeschleunigende Wirkung auf die Bildung von $ZnCl_2$ respektive $H^+$-

(ZnCl$_2$OH)$^-$ zurückgeführt wird (A. Giller; Kautschuk und Gummi, Kunststoffe, 19, 188-197 (1966)). Als besonders geeignet erweisen sich Cl-sulfoniertes Polyethylen sowie Polychloroprenkautschuk als polymere Cl-Spender. Auch anorganische Metallhalogenide, wie ZnCl$_2$ können als Beschleuniger eingesetzt werden.

Typische Einsatzkonzentrationen der Hilfsstoffe betragen beispielsweise:

Zn-Resinat (ca. 9% Zn-Gehalt) 0 - 15 Gew.-Teile
pro 100 Gew.-Teile Schmelzhaftkleber
bevorzugt 1 - 8 Gew.-Teile
pro 100 Gew.-Teile Schmelzhaftkleber
saure Harze (Säurezahl ca. 150) 0 - 15 Gew.-Teile
pro 100 Gew.-Teile Schmelzhaftkleber
bevorzugt 1 - 8 Gew.-Teile
pro 100 Gew.-Teile Schmelzhaftkleber
wenn als Klebharz genutzt bis 70 Gew.-Teile
pro 100 Gew.-Teile Schmelzhaftkleber
in Kombination mit ZnO (aktiv) 0 - 30 Gew.-Teile
pro 100 Gew.-Teile Schmelzhaftkleber
bevorzugt 1 - 20 Gew.-Teile
pro 100 Gew.-Teile Schmelzhaftkleber
Cl-Spender Cl-Sulfoniertes Polyethylen (Cl-Gehalt ca. 30%) 0 - 5 Gew.-Teile Schmelzhaftkleber bevorzugt 0.1 - 1.5 Gew.-Teile
pro 100 Gew.-Teile Schmelzhaftkleber.

Zur Herstellung des reaktiven Primers werden die reaktive Komponente bzw. der Vernetzer, gegebenenfalls die Hilfsstoffe und Zusatzstoffe und die Bestandteile des Primers zusammengegeben und vermischt. Die Beschichtungen der Träger erfolgen in üblicher Weise mit bekannten Auftragsvorrichtungen.

Zur Vorvernetzung der erfindungsgemäßen Schmelzhaftklebemasse eignen sich alle Arten energiereicher und ionisierender Strahlung, wie $\alpha$-, $\beta$-, Gamma- und Röntgenstrahlung sowie, nach Zufügen geeigneter Sensibilisatoren (UV-Initiatoren) UV-Strahlung. Für die Erzeugung von $\beta$-Strahlen sind leistungsfähige Elektronenbeschleuniger entwickelt worden, die für diese Erfindung bevorzugt werden. Die Eindringtiefe dieser Strahlen und damit die maximale Dicke der zu vernetzenden Beschichtung wird von der Beschleunigerspannung bestimmt. Die absorbierte Strahlendosis kann aus dem Strahlstrom und der Bahngeschwindigkeit berechnet werden (D.J.StClair; Adhs. Age 23(3), 30-35 (1980)). Geeignete Vorvernetzungsdosen (absorbierte Dosis) liegen im Falle der Vernetzung mit Hilfe von beschleunigten Elektronen z.B. im Bereich zwischen 5 und 100 kGray, bevorzugt jedoch im Bereich zwischen 20 und 60 kGray, wobei günstigerweise Beschleunigungsspannungen zwischen 150 KeV und 500 keV eingesetzt werden. In (J.R.Erickson; TAPPI Hot Melt Symposium, 1-12 (1985); J.R.Erickson; Techn. Sem. Proc., 76-97 (1985)) beschriebene sternförmige Blockcopolymere benötigen i.a. keine zusätzlichen Vernetzer um zu ausreichenden Vorvernetzungsgraden zu gelangen.

Für bei den angegebenen Strahlendosen nicht ausreichend vernetzende Systeme können dem Schmelzhaftkleber zusätzliche Vernetzungskomponenten zugesetzt werden. Geeignet sind multifunktionelle (Meth)acrylate wie z.B. TMPTA oder auch multifunktionelle Polythiole. Einsatzkonzentrationen dieser Verbindungen liegen z.B. zwischen 0,3 und 20 Gew.-Teile pro 100 Gew.-Teile Heißschmelzkleber, bevorzugt jedoch im Bereich von 3 Gew.-Teile bis 15 Gew.-Teile pro 100 Gew.-Teile Schmelzhaftkleber. Da die Vernetzung über multifunktionelle Vernetzungskomponenten auch thermisch initiiert werden kann, kann es in diesem Fall während der Herstellungs- und Beschichtungsprozesse der Schmelzhaftkleber zweckmäßig sein, auf niedrige Verarbeitungstemperaturen und/oder kurze Verweilzeiten bei erhöhter Temperatur zu achten (D.J.StClair Adhes. Age 23(3) 30-35 (1980)). Nach Durchführung der Vorvernetzung liegt der Gelwert (s.u.) vorzugsweise über 40% und besonders bevorzugt über 60%. Für die jeweilige Anwendung können der Vorvernetzungsgrad und das Nachvernetzungsverhalten spezifisch aufeinander abgestimmt werden. Soll z.B. ein über den Gesamttemperaturbereich von Raumtemperatur bis +180°C scherfestes Haftklebematerial oder Klebeband hergestellt werden, ist es günstig, den Vorvernetzungsgrad so hoch zu wählen, daß vor Einsetzen der Nachvernetzung keine zu starke Erweichung der Selbstklebemasse einsetzt. Wird eine Vernetzung durch Bestrahlung mit UV-Licht beabsichtigt, so ist der Klebemasse vorzugsweise ein Photoinitiator zuzusetzen (J.R.Erickson; TAPPI Hot Melt Symposium, 1-12 (1985), J.R.Erickson; Techn. Sem. Proc., 76-97 (1985)). Einsatzkonzentrationen an Photoinitiator betragen z.B. 1 bis 20 Gew.-Teile pro 100 Gew.-Teile Schmelzhaftkleber, bevorzugt 3 bis 15 Gew.-Teile Schmelzhaftkleber. Als UV-Initiatoren sind neben anderen substituierte Acetophenone wie 2,2-Dimethoxy-2-phenylacetophenon (Irgacure 651, Firma Ciba-Geigy) oder 2-Hydroxy-2-methyl-1-phenyl-propan-1-one (Darocure 1173, Firma Merck) geeignet.

Das Verfahren zur Herstellung der erfindungsgemäßen Haftklebematerialien, insbesondere blattförmigen oder bahnförmigen Materialien mit einseitig oder beidseitig aus der Schmelze aufgetragener Haftklebemasseschicht und reaktiver Primerschicht ist dadurch gekennzeichneit, daß auf einen Träger oder die blattförmigen oder bahnförmigen Materialien einseitig oder beidseitig eine reaktive Primerschicht aufgebracht wird und auf die Primerschicht eine Schmelzhaftkleberschicht aufgebracht wird und die Schmelzhaftkleberschicht vorvernetzt wird.

Die erfindungsgemäßen Haftklebematerialien, z.B. Selbstklebebänder, eignen sich insbesondere für Anwendungen, bei denen sie im verklebten Zustand einer erhöhten Temperatur ausgesetzt werden, welche den Vernetzungsprozeß initiiert. Die eintretende Nachvernetzung der Selbstklebemasse erzeugt die gewünschte Steigerung der Massekohäsivität, welche zu einem verbesserten Scherverhalten führt. Typische Anwendungen beinhalten Abdeckbänder zur Abdeckung zu schützender Flächen und zur Verklebung von Maskenpapieren im Lackierbereich, insbesondere für Automobillackierungen. Die thermisch initiierte Nachvernetzung der Haftklebemassen der verwendeten Abdeckbänder ermöglicht einerseits eine sichere Fixierung der Masken, zum zweiten läßt sich das bei nicht nachvernetzenden Klebemassen üblicherweise zu beobachtende starke Aufziehen (= Steigerung der Schälkraft) der Abdeckbänder nach Temperaturexposition auf dem Substratgrund verhindern. Für die genannten Abdeckbänder finden als Trägermaterialien sowohl Papiere als auch Folien Verwendung. Weitere Anwendungsbereiche schließen u.a. Selbstklebebänder für Abdeckanwendungen im Elektrobereich, wie beispielsweise (permanente) Spulenabdeckungen oder (temporäre) lötbadbeständige Abdeckungen für elektronische Leiterplatten ein.

Zur Charakterisierung der erfindungsgemäßen Klebebänder sind insbesondere Methoden geeignet, die den Vernetzungsgrad der Selbstklebemasse sowie die temperaturabhängige Scherfestigkeit messen. Für nachfolgend beschriebene Beispiele werden Gelwertbestimmungen und Thermoscherwegmessungen zur Charakterisierung herangezogen.

Als Gelwert soll der Anteil vernetzter Polymerbestandteile der Schmelzhaftklebemasse, bezogen auf den Gesamtgehalt an Blockcopolymer verstanden werden. Zur Bestimmung des Gelwertes wird die Masse eines vor- und/oder nachvernetzten Klebebandmusters vor und nach 24 Stunden Extraktion mit Toluol bestimmt. Aus der ermittelten Massedifferenz läßt sich der Gelwert rechnerisch ermitteln.

Bei der Thermoscherwegmessung wird das zu charakterisierende Klebebandmuster auf einer vertikal angebrachten, beheizbaren 13 mm x 20 mm großen Verklebungsfläche aus Stahl aufgebracht und bei konstanter Scherbeanspruchung von 0.49 N linear mit einem Temperaturgradienten von 5 K/min erwärmt. Gemessen wird der Scherweg als Funktion der Zeit (Temperatur). Die Methode ermöglicht es Aussagen über den Vernetzungszustand der Probe zu erhalten.

Die verwendeten Stoffe sind bekannt oder im Handel erhältlich.

Alle Mengenangaben, Anteile und Prozentanteile sind, soweit nicht anders angegeben, auf das Gewicht und die Gesamtmenge der Zubereitung oder jeweiligen Komponente, bezogen.

Nachfolgend wird die Erfindung anhand von Beispielen erläutert, ohne diese damit einschränken zu wollen.

Beispiel 1

Ein 100 μm starker mit einem Acrylestercopolymer imprägnierter Krepp-Papierträger wird mit einem 15%igen toluolhaltigen wässrigen Dispersionsprimer bestehend aus (alle Angaben bezogen auf Gew.-Teile Feststoff):

40 Gew.-Teile Zentrifugenlatex

20 Gew.-Teile Alkylphenolharz mit Erweichungspunkt

(R&B) +77°C und einem Methylolwert von 12.5%

(Vulkaresen PA 130, Fa. Hoechst)

2 Gew.-Teile Zinkresinat (9% Zn) (Erkazit 165, Fa. R. Kraemer)

30.9 Gew.-Teile Sillitin Z86, Kieselerde

4 Gew.-Teile Benetzungsmittel (Emulvin W, Fa. Bayer)

3 Gew.-Teile Verdicker (Collacral VL, Fa. BASF)

0.1 Gew.-Teile Entschäumer (Agitan 217, Fa. Münzing)

in einer Schichtstärke von 6 g/m² (bezogen auf Feststoff) beschichtet und im Umlufttrockenschrank 5 min. bei +100°C getrocknet.

In einem zweiten Prozeßschritt wird ein Schmelzhaftkleber bestehend aus:

50 Gew.-Teile eines sternförmigen (S-I)nX

Blockcopolymers mit über GPC (Eichung über Polystyrolstandard) ermittelter mittlerer Molmasse (Mn) von 690000 Dalton und einem über NMR bestimmten Blockpolystyrolgehalt von 10% (Kraton D 1320 X, Fa. Shell)

36 Gew.-Teile eines synthetischen KW-Harzes vom Erweichungspunkt +95°C (Wingtack 95, Fa. Goodyear)

6 Gew.-Teile Zn-Resinat (9% Zn) (Erkazit 165)

7 Gew.-Teile eines aliphatischen Öles von der mittleren Molmasse 530 Dalton (V 7047, Shell)

1 Gew.-Teil eines phenolischen Antioxidantes (BHT)

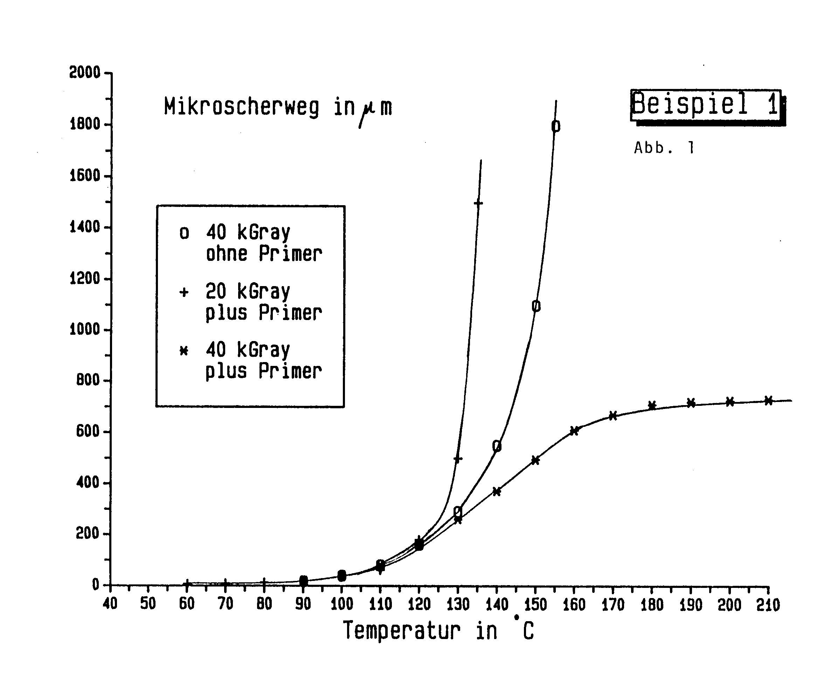

in einer Schichtstärke von 50 g/m$^2$ auf den geprimerten Träger und zum Vergleich auf den nicht geprimerten Träger beschichtet. Die erhaltenen Klebebandmuster werden über Elektronen-Bestrahlung (Beschleunigerspannung 165 kV) mit Dosen von 20 und 40 kGray vorvernetzt. Wie aus Abb.1 und Tabelle I hervorgeht, wird für das Klebebandmuster, welches einen Reaktivvorstrich trägt und mit 40 kGray bestrahlt ist, im Mikroscherwegexperiment eine thermisch induzierte Nachvernetzung nachgewiesen. Die übrigen Muster scheren vor Erreichen der Vernetzungstemperatur vom Stahluntergrund ab.

Beispiel 2

Ein Schmelzhaftkleber bestehend aus 42,5 Gew.-Teile sternförmiges Multiblockcopolymer (analog Beispiel 1) 20 Gew.-Teile eines cyclisch modifizierten aliphatischen KW-Harzes vom Erweichungspunkt 117°C (Escorez 1401, Fa. Exxon) 5 Gew.-Teile eines Terpenphenolharzes vom Erweichungspunkt +125°C (Alresen PK 500, Fa. Hoechst) 6 Gew.-Teile Zn-Resinat (9% Zn) (Erkazit 165) 10 Gew.-Teile eines aliphatenreichen Öles (V 7047, Shell) 15 Gew.-Teile Mikrotalkum 0,5 Gew.-Teile Cl-sulfoniertes Polyethylen mit einem

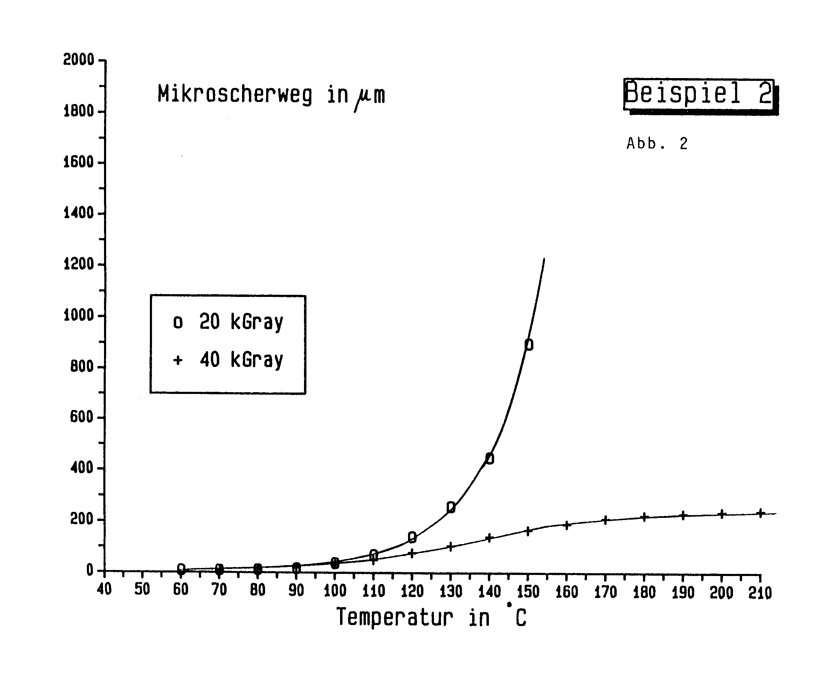

Cl-Gehalt von 29% und einer Brookfieldviskosität (25%ig in Toluol, +25°C) von 1,3 Pa•s 1,5 Gew.-Teile phenolisches Antioxidans (BHT) wird in einer Schichtstärke von 50 g/m$^2$ auf den geprimerten Träger aus Beispiel 1 beschichtet und mit Strahlendosen von 20 kGray und 40 kGray über EB-Strahlung vorvernetzt. Wie Tabelle 1 und Abb. 2 zeigen, tritt im Mikroscherwegexperiment für das Muster mit und 40 kGray Vorvernetzerdosis thermisch induzierte Nachvernetzung ein, wobei der beobachtete Scherwert bei T = +200°C deutlich unterhalb des Vergleichsmusters aus Beispiel 1 liegt.

Beispiel 3

Der unter Beispiel 2 näher gekennzeichnete Schmelzhaftkleber wird in einer Schichtstärke von 50 g/m$^2$ auf den unter Beispiel 1 aufgeführten beschichteten Träger aufgetragen, wobei das unter Beispiel 1 eingesetzte Alkylphenolharz (Harz B) gegen ein solches höherer Reaktivität (Harz C; Erweichungspunkt R&B: +77°C, Methylolwert = 7.5% (= Vulkaresen PA 510, Fa. Hoechst) und ein solches geringerer Reaktivität (Harz A; Schenectady FX RA 165).

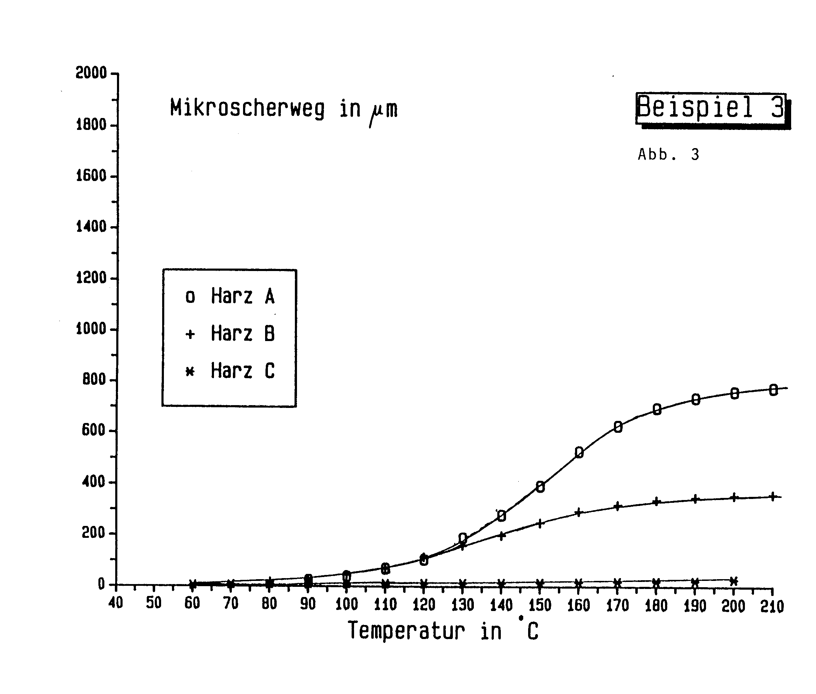

Die erhaltenen Muster werden über Elektronen-Bestrahlung mit einer Dosis von 40 kGray (Beschleunigerspannung 165 kV) vorvernetzt. Die erhaltenen Reaktivitätsunterschiede lassen sich der Tabelle 1 sowie Abb. 3 entnehmen.

Beispiel 4

Ein Schmelzhaftkleber bestehend aus:

48.8 Gew.-Teile eines linearen SIS-Dreiblockcopolymers

mit ca. 20% 2-Blockgehalt, einer über GPC (Eichung über Polystyrolstandard) ermittelten Molmasse von 200 kDalton (Peakmaximum) der Dreiblockkomponente und einem über NMR bestimmten Blockpolystyrolgehalt von 14% (Cariflex TR 1107, Fa. Shell),

34.2 Gew.-Teile eines synthetischen KW-Harzes vom

Erweichungspunkt +95°C (Wingtack 95)

6.0 Gew.-Teile Zn-Resinat (9% Zn) (Erkazit 1165)

10.0 Gew.-Teile

2-Ethyl-2-(hydroxymethyl)-1,3-propanedioltriacrylat (TMPTA; multifunktioneller Vernetzer)

1.0 Gew.-Teile phenolisches Antioxidans (BHT)

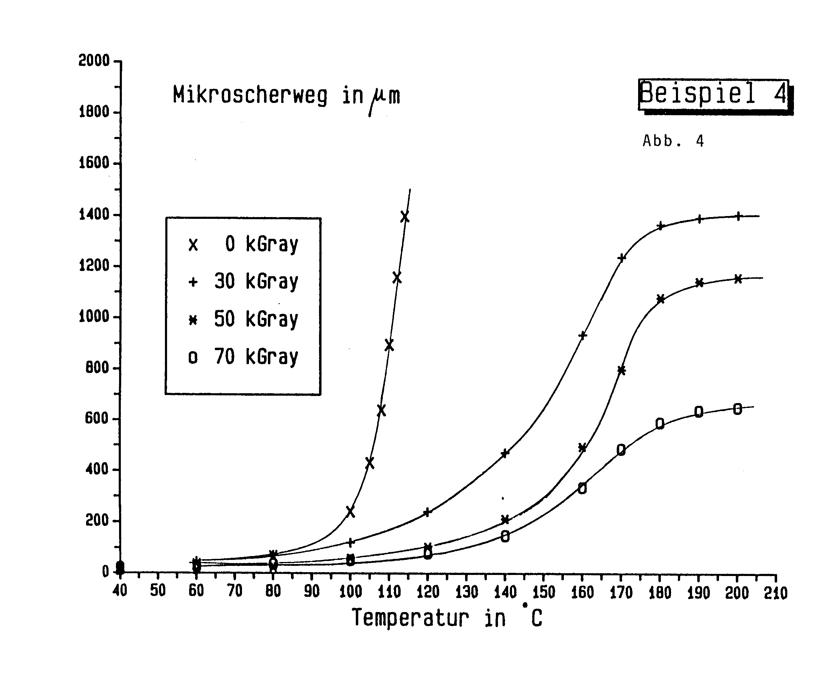

wird in einer Schichtstärke von 60 g/m$^2$ auf den geprimerten Träger aus Beispiel 1 aufgetragen und über EB-Strahlung (Beschleunigerspannung 165 kV) mit Dosen von 0, 30, 50 und 70 kGray vorvernetzt. Die Ergebnisse der Mikroscherwegmessungen sind der Tabelle 1 und Abb. 4 zu entnehmen.

| Beispiel | reaktiver Vorstrich | Vorvernetzungsdosis in kGray | Thermoscherweg bei T=+200°C in µm | Gelgehalt vor Nachvernetzung in % |
|---|---|---|---|---|
| 1 | - | 40 | > 2000 | 78.4 |
|   | + | 0 | > 2000 | - |
|   | + | 20 | > 2000 | 60.9 |
|   | + | 40 | 1400 | 76.3 |
| 2 | - | 40 | > 2000 | |
|   | + | 20 | > 2000 | |
|   | + | 40 | 700 | |
| 3 | + | 40 | 1440 | |
|   | + | 40 | 700 | |
|   | + | 40 | 60 | |
| 4 | + | 0 | > 2000 | - |
|   | + | 30 | 1390 | 73.6 |
|   | + | 50 | 1020 | 87.6 |
|   | + | 70 | 640 | 90.3 |

Tabelle 1: Ergebnisse der Mikroscherwerkexperimente und Gelwertbestimmungen zu den Beispielen 1 bis 4

**Patentansprüche**

1. Haftklebematerialien, insbesondere blattförmige oder bahnförmige Materialien mit einseitig oder beidseitig aus der Schmelze aufgetragener Haftklebemasseschicht, dadurch gekennzeichnet, daß die Haftklebemasseschicht vernetzt ist und auf eine reaktive Primerschicht aufgetragen ist.

2. Haftklebematerialien gemäß Anspruch 1 mit einem Träger, insbesondere blattförmigen oder bahnförmigen Materialien mit einseitig oder beidseitig aus der Schmelze aufgetragener Haftklebemasseschicht, dadurch gekennzeichnet, daß die Haftklebemasseschicht vorvernetzt ist und auf eine reaktive Primerschicht aufgetragen ist, die zuvor auf die Materialien aufgebracht wurde und die durch nachträglich erfolgende Erwärmung eine zusätzliche Vernetzung der Haftklebemasse bewirkt.

3. Haftklebematerialien gemäß Anspruch 1, dadurch gekennzeichnet, daß die reaktive Primerschicht einen Primer und einen Vernetzer, vorzugsweise ein Vulkanisationsharz enthält.

4. Verfahren zur Herstellung der Haftklebematerialien gemäß Anspruch 1, insbesondere blattförmigen oder bahnförmigen Materialien mit einseitig oder beidseitig aus der Schmelze aufgetragener Haftklebemasseschicht und reaktiver Primerschicht, dadurch gekennzeichnet, daß auf einen Träger oder die blattförmigen oder bahnförmigen Materialien einseitig oder beidseitig eine reaktive Primerschicht aufgebracht wird und auf die Primerschicht eine Schmelzhaftkleberschicht aufgebracht wird und die Schmelzhaftkleberschicht vorvernetzt wird.

5. Haftklebematerialien nach Anspruch 1, dadurch gekennzeichnet, daß die Schmelzhaftklebemasse als Basiselastomer 15 bis 60 Gew.-Teile Blockcopolymere pro 100 Gew.-Teile Schmelzhaftkleber enthält, welche Polyvinylaromatenblöcke und Polydienblöcke enthalten, wobei die Polydienblöcke wahlweise partiell hydriert sein können.

6. Haftklebematerialien nach Anspruch 1, dadurch gekennzeichnet, daß die Schmelzhaftklebemasse als Basiselastomer sternförmige Blockcopolymere der allgemeinen Struktur (A-B)nX enthält, wobei A einen Polystyrolblock, B einen Polydienblock und X eine multifunktionelle Kopplungskomponente darstellt.

7. Haftklebematerialien nach Anspruch 1, dadurch gekennzeichnet, daß die Haftklebemasse zur Erhöhung der Strahlenvernetzung 0,3 bis 20 Gew.-Teile pro 100 Gew.-Teile Schmelzhaftkleber multifunktionelle Vernetzer enthält.

8. Haftklebematerialien nach Anspruch 1, dadurch gekennzeichnet, daß die reaktive Primerschicht (Vorstrich) 0,2 bis 10 Gew.-Teile pro 100 Gew.-Teile Blockcopolymer in der Haftklebemasse an Vulkanisationsharzen, insbesondere reaktiven Phenolharzen enthält.

9. Haftklebematerialien nach Anspruch 1, dadurch gekennzeichnet, daß dem Primer und/oder dem Haftkleber 0,2 bis 15 Gew.-Teile pro 100 Gew.-Teile Primer eines organischen Zinkspenders als Vulkanisationsbeschleuniger zugesetzt sind.

10. Haftklebematerialien nach Anspruch 9, dadurch gekennzeichnet, daß der organische Zinkspender durch Kombination einer organischen Säure und einem anorganischen Zinksalz erzeugt wird.

11. Haftklebematerialien nach Anspruch 1, dadurch gekennzeichnet, daß die Haftklebemasse 0,02 bis 10 Gew.-Teile, bevorzugt 0,1 bis 1,5 Gew.-Teile pro 100 Gew.-Teile Schmelzhaftkleber niedermolekulare und/oder polymere Halogenspender als Vulkanisationsbeschleuniger enthält.

12. Haftklebematerialien nach einem der Anspruch 1, dadurch gekennzeichnet, daß die Haftklebemasse 0,01 bis 5 Gew.-Teile, bevorzugt 0,05 bis 0,5 Gew.-Teile pro 100 Gew.-Teile Schmelzhaftkleber Metallhalogenide wie $ZnCl_2$ als Vulkanisationsbeschleuniger enthält.

13. Haftklebematerialien gemäß Anspruch 1, dadurch gekennzeichnet, daß die Haftklebemasseschicht durch Bestrahlung mit Elektronen vernetzt ist.

**14.** Haftklebematerialien nach Anspruch 1, dadurch gekennzeichnet, daß die Haftklebemasse nach der Beschichtung mit beschleunigten Elektronen von 150 bis 500 keV Energie und einer absorbierten Dosis im Bereich zwischen 5 bis 100 kGray vernetzt ist.

**15.** Haftklebematerialien nach Anspruch 1, dadurch gekennzeichnet, daß die Haftklebemasse nach Zusatz von 1 bis 20 Gew.-Teilen Photoinitiator pro 100 Gew.-Teile Schmelzhaftkleber durch nachfolgende UV-Bestrahlung vernetzt ist.

Mikroscherweg in μm

**Beispiel 1**

Abb. 1

Legend:
- o  40 kGray ohne Primer
- +  20 kGray plus Primer
- *  40 kGray plus Primer

Temperatur in °C

EP 0 668 335 A2

Mikroscherweg in μm

Beispiel 2

Abb. 2

o  20 kGray
+  40 kGray

Temperatur in °C

EP 0 668 335 A2

Mikroscherweg in μm

Beispiel 3

Abb. 3

o Harz A
+ Harz B
* Harz C

Temperatur in °C

EP 0 668 335 A2

Mikroscherweg in μm

Beispiel 4

Abb. 4

Legend:
- x  0 kGray
- +  30 kGray
- *  50 kGray
- o  70 kGray

Temperatur in °C